# EUROPÄISCHE PATENTSCHRIFT

(11) **EP 2 031 641 B1**
(45) Veröffentlichungstag und Bekanntmachung des Hinweises auf die Patenterteilung: **22.02.2012**
(21) Anmeldenummer: 07017128.5
(22) Anmeldetag: 31.08.2007
(51) Int. Cl.: H01L 21/20, H01L 21/02

(54) **Halbleiterbauelement und dessen Verwendung**
Semiconductor element and its use
Composant semi-conducteur et son utilisation

(43) Veröffentlichungstag der Anmeldung: 04.03.2009
(73) Patentinhaber: Fraunhofer-Gesellschaft zur Förderung der angewandten Forschung e.V., 80686 München (DE)
(72) Erfinder: Dimroth, Frank, Dr., 79115 Freiburg (DE); Schöne, Jan, Dipl.-Ing., 79104 Freiburg (DE)
(74) Vertreter: Pfenning, Meinig & Partner GbR

(56) Entgegenhaltungen:
- WO-A-03/007353
- WO-A-2007/096405
- DE-A1- 10 203 393
- US-A1- 2003 136 333
- US-A1- 2006 118 810
- US-A1- 2007 045 639

## Beschreibung

Die vorliegende Erfindung betrifft ein Halbleiterbauelement aus einem Substrat, einer Schichtstruktur aus einem III-V-Halbleiter und einer Pufferschicht zur Verbindung der Schichtstruktur mit dem Substrat, wobei in die Bauelement-Struktur eine zusätzliche "Blockerschicht" eingefügt ist, die gezielt die Ausbildung oder Fortsetzung von Kristalldefekten in nachfolgende Schichten verhindert. Die Erfindung betrifft weiterhin die Verwendung der Halbleiterbauelemente als Solarzelle oder als Leuchtdiode.

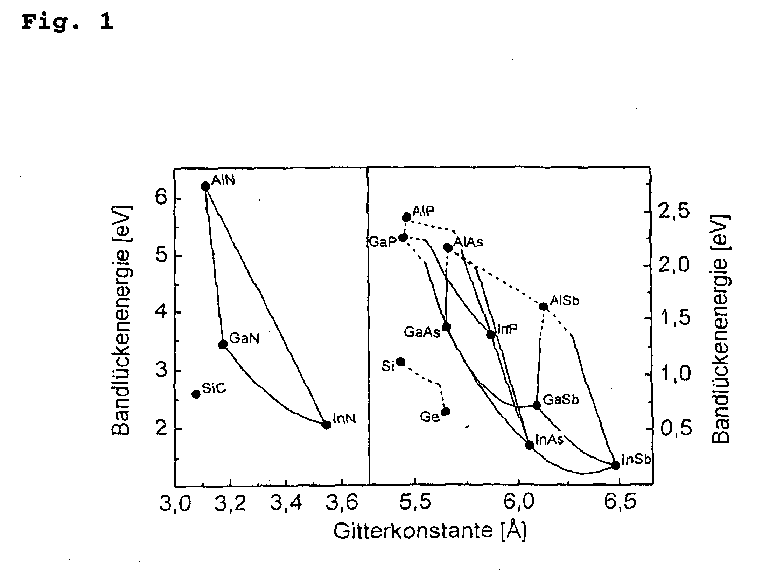

Der Aufbau von Halbleiterbauelementen aus spezifisch ausgewählten III-V-halbleitenden Schichtstrukturen sowie ein Substrat und einer das Substrat und die Schichtstruktur verbindenden Pufferschicht ist im Stand der Technik bekannt. Die III-V-Verbindungshalbleiter der Schichtstruktur aus drei oder mehr Elementen ermöglichen dabei durch Variation der Zusammensetzung das gezielte Anpassen der Bandlücke und/oder der Gitterkonstante, das sog. "bandgapengineering" (siehe hierzu Figur 1).

Verbindungshalbleiter spielen somit eine wichtige Rolle in der Herstellung von optischen Bauelementen, wie hocheffizienten III-V-Solarzellen oder Laserdioden. Hierbei wird die Bandlücke der Verbindungshalbleiter, wie z.B. GaInAs oder GaInP derart angepasst, dass Sonnenlicht innerhalb der Solarzelle möglichst effizient absorbiert bzw. Laserlicht einer bestimmten Wellenlänge emittiert werden kann. Ternäre Verbindungshalbleiter besitzen lediglich einen Freiheitsgrad, d.h. Bandlücke und Gitterkonstante können nicht unabhängig voneinander variiert werden. Die meisten ternären Verbindungshalbleiter mit einer optimalen Bandlücke können deshalb nur gitterfehlangepasst auf singuläre oder binäre Substrate, wie Ge oder GaAs, abgeschieden werden. Beim gitterfehlangepassten Schichtwachstum entstehen Gitterspannungen, die oberhalb einer kritischen Schichtdicke durch den Einbau von Fehlanpassungsversetzungen relaxieren. Hierbei entstehen zusätzlich Fadenversetzungen, die bis in die aktiven Schichten hineinreichen können, wo sie die elektronischen Eigenschaften der Bauelemente herabsetzen.

Im Stand der Technik sind verschiedene Möglichkeiten beschrieben, um die Versetzungsdichte in den aktiven Schichten zu verringern. Neben der gebräuchlichsten Variante, die Substrat-Gitterkonstante schrittweise oder linear innerhalb einer Pufferstruktur an die Gitterkonstante der epitaktischen Schicht anzupassen, gibt es weitere relevante Verfahren. Beispielsweise wurden durch die Anwendung von verspannten Übergittern Versetzungsdichten in GaAs auf Si von ~10⁶ erzielt (M. Yamaguchi, T. Nishioka, M. Sugo, Appl. Phys. Lett. 54(1), 1989, 24-26). Hierbei werden Versetzungen durch das abwechselnde Aufwachsen von dünnen (einige nm) verspannten Schichten umgebogen und so aus den aktiven Schichten ferngehalten. Ein weiteres Verfahren zur Reduzierung von Versetzungen ist der gezielte Einsatz von unterschiedlichen Ausheilverfahren.

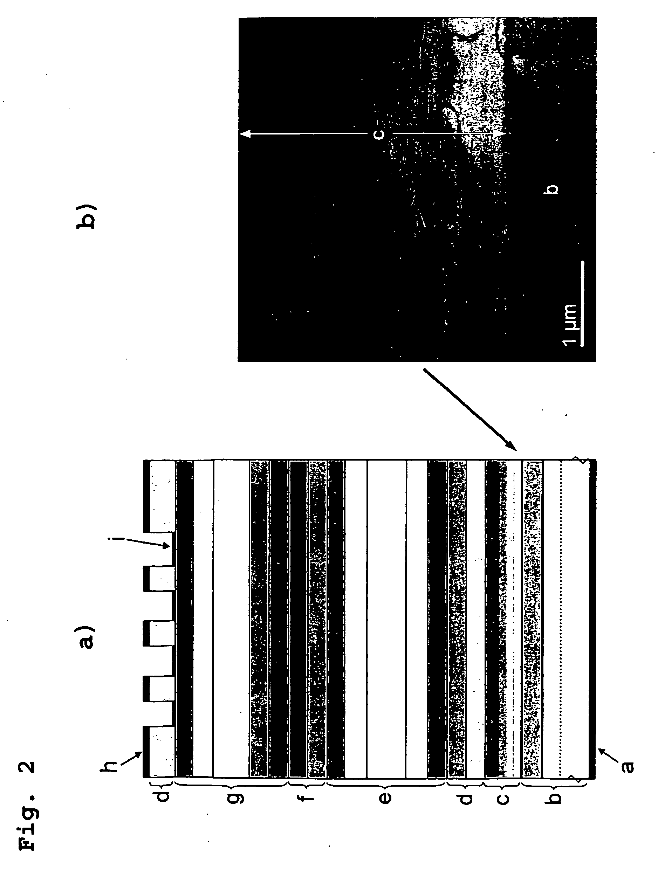

Ferner ist aus A. W. Bett et al. in MRS Symp. Proc. Vol. 836 (Materials for Photovoltaics), 2005, 223-234, bekannt, Pufferstrukturen mit stufenweise erhöhtem In-Gehalt einzusetzen, um gitterfehlangepasste GaInP/GaInAs-Solarzellenschichten defektfrei auf einem aktivierten Ge-Substrat abscheiden zu können. Figur 2a zeigt hierzu eine Prinzipskizze einer gitterfehlangepassten GaInP/GaInAs/Ge-Tripelsolarzelle. Die TEM-Hellfeldabbildung in Figur 2b zeigt ein Netzwerk von Versetzungen in der Pufferstruktur. Die Fehlanpassungsversetzungen in den Grenzflächen sorgen für einen Abbau der Schichtspannungen aufgrund unterschiedlicher Gitterkonstanten der Materialien. Die Versetzungsdichten in III-V-Halbleiterschichten auf einer solchen Pufferstruktur liegen im Bereich von 10⁶ cm⁻² bei einer Fehlanpassung der Gitterkonstanten von 1.1 %. Diese Versetzungsdichten wirken sich bereits negativ auf den erreichbaren Wirkungsgrad der Solarzellen aus.

Ähnlich wie bei einer Fehlanpassung der Gitterkonstanten in den Halbleiterschichten führen unterschiedliche thermische Ausdehnungskoeffizienten der Materialien zu Spannungen beim Abkühlen der Struktur nach dem Wachstumsprozess. Auch hierbei kann es zur Bildung von Versetzungen und Rissen in den Halbleiterschichten kommen. Dies findet man heute insbesondere bei III-V-Halbleiterschichten auf Siliciumsubstraten, wo die Unterschiede in den thermischen Ausdehnungskoeffizienten besonders groß sind.

Die meisten optoelektronischen Bauelemente aus III-V-Verbindungshalbleitern, wie Photovoltaikzellen oder Leuchtdioden, werden heute somit gitterangepasst zu einem Substratmaterial gewachsen. Oftmals bieten jedoch Materialkombinationen mit einer anderen Gitterkonstante die Möglichkeit, solche Bauelemente weiter zu optimieren. Bei gitterfehlangepassten Strukturen entstehen ab einer kritischen Schichtdicke Versetzungen, die als Rekombinationszentren für Minoritätsladungsträger in den aktiven Schichten des Bauelements wirken. Dadurch wird die Qualität der Bauelemente begrenzt. Bei Solarzellen sind Versetzungsdichten im Bereich von 10⁵ cm⁻² notwendig, um eine sehr gute Effizienz und Leistungsdichte zu erzielen. Im Falle von hohen Gitterfehlanpassungen von über 1 % werden solche niedrigen Versetzungsdichten aber bis heute nicht erreicht.

Aufgabe der vorliegenden Erfindung ist es daher, ein Halbleiterbauelement anzugeben, das eine Schichtstruktur aufweist, durch die Versetzungsdichten in gitterfehlangepassten III-V-Halbleiterstrukturen reduziert oder beseitigt werden. Weiterhin soll das Problem von Rissen und Versetzungen in Halbleiterschichten mit unterschiedlichen thermischen Ausdehnungskoeffizienten ebenfalls reduziert bzw. beseitigt werden.

Diese Aufgabe wird durch die kennzeichnenden Merkmale des Patentanspruchs 1 gelöst. Die Unteransprüche zeigen vorteilhafte Weiterbildungen auf. Erfindungsgemäß wird somit vorgeschlagen, in die Bauelementstruktur eines Halbleiters aus einem Substrat, mindestens einer Schichtstruktur aus einem III-V-Verbindungshalbleiter und/oder SiₓGe₁₋ₓ, die einen pn- oder np-Übergang bildet, sowie mindestens einer Pufferschicht zur Verbindung der Schichtstruktur mit dem Substrat, zusätzlich mindestens eine Blockerschicht in die Bauelementstruktur einzufügen. Die erfindungsgemäße Blockerschicht muss dabei eine größere Kristallhärte als die der mindestens einen Schichtstruktur aufweisen.

Es hat sich nun gezeigt, dass durch das Einfügen dieser "Blockerschichten" in die Bauelementstruktur die Versetzungsdichten in gitterfehlangepassten Halbleiterstrukturen deutlich reduziert wurden. Darüber hinaus ermöglichen die Blockerschichten eine flexible Handhabung und einen gezielten Einsatz innerhalb der Struktur. So können die Blockerschichten z.B. um eine Schichtstruktur herum gelegt werden, um Versetzungen von beiden Seiten abzublocken. Die Vielzahl der möglichen Materialkombinationen erlaubt eine hohe Flexibilität in der Wahl der Gitterkonstante und der Bandlücke der Blockerschichten. Es hat sich weiterhin gezeigt, dass durch die Blockerschichten zusätzlich das Problem von Rissen und Versetzungen in Halbleiterschichten mit unterschiedlichen thermischen Ausdehnungskoeffizienten deutlich gemindert werden konnte.

Die "Blockerschicht" im erfindungsgemäßen Halbleiterbauelement zeichnet sich besonders dadurch aus, dass seine Kristallhärte mindestens 10 %, bevorzugt 15 % größer ist als die Kristallhärte der Schichtstruktur. Die Bestimmung der Kristallhärte von Schichtstrukturen ist im Stand der Technik bekannt. Hierzu wird auf B. Jönsson, S. Hogmark, "Hardness Measurements of Thin Films", Thins-Solid Films, 114 (1984), Seiten 257-269, verwiesen.

Ein weiteres wesentliches Kennzeichen der Blockerschicht beim erfindungsgemäßen Halbleiterbauelement ist die Dicke. Es hat sich gezeigt, dass es bevorzugt ist, wenn die Dicke der Blockerschicht so gewählt wird, dass sie unterhalb der kritischen Schichtdicke für die Relaxation des Halbleiters liegt. Als Dicken für die Halbleiterschichten sind dabei 10 bis 500 nm, bevorzugt 10 bis 200 nm zu nennen.

Ein weiterer wesentlicher Vorteil des erfindungsgemäß beschriebenen Halbleiterbauelementes ist darin zu sehen, dass die Blockerschichten gezielt in die Bauelementstruktur eingefügt werden können, so dass dadurch auch z.B. Versetzungen von beiden Seiten eines aktiven Bereiches, d.h. einer Schichtstruktur, abgeblockt werden können. Bevorzugt ist es dabei, wenn mindestens eine Blockerschicht in der mindestens einen Pufferschicht angeordnet ist. Die Blockerschicht kann dabei oberhalb oder unterhalb der Pufferschicht vorgesehen sein oder aber die Blockerschicht ist in der Mitte einer Pufferschicht angeordnet, d.h. sie durchtrennt die Pufferschicht selbst. Weitere Möglichkeiten zur Anordnung der Blockerschicht bestehen darin, dass die Blockerschicht auch unterhalb und oberhalb der Pufferschicht vorgesehen sein kann. In diesem Falle, d.h. wenn die Blockerschicht oberhalb und unterhalb der Pufferschicht vorgesehen ist, schließt die Blockerschicht die Pufferschicht sandwichartig ein.

Das erfindungsgemäße Halbleiterbauelement kann selbstverständlich auch so aufgebaut sein, dass mehrere Schichtstrukturen, die einen pn-Übergang oder einen np-Übergang bilden, übereinander angeordnet sind. Beim Anwendungsfall Solarzellen handelt es sich damit um sog. "Mehrfachsolarzellen". In diesem Falle kann dann die Blockerschicht auch zwischen den einzelnen Schichtstrukturen der jeweiligen Einzelzellen vorgesehen sein.

Die Erfindung umfasst dabei auch Ausführungsformen, bei denen das Substrat nicht als reiner Träger fungiert, sondern, dass das Substrat selbst ein "aktives" Substrat ist. So ist es z.B. möglich, die Aktivierung dadurch durchzuführen, dass ein integrierter pn- bzw. np-Übergang durch Eindiffundieren von weiteren Elementen, wie Phosphor oder Bor, in ein Siliciumsubstrat, hergestellt wird. Erfindungsgemäß umfasst deshalb der Begriff "aktiviertes Substrat" ein wie vorstehend definiertes Substrat, das einen pn- bzw. np-Übergang aufweist und wobei zusätzlich noch eine Pufferschicht, die auf dem Substrat angeordnet ist, vorgesehen ist. In diesem Falle ist es dann bevorzugt, wenn zwischen der Pufferschicht und dem aktivierten Substrat zusätzlich noch eine Blockerschicht angeordnet ist.

Die Blockerschicht, die in dem erfindungsgemäßen Bauelement eingebaut ist, ist dabei aus stofflicher Sicht aus einem III-V-Halbleiter aufgebaut. Der III-V-Halbleiter enthält dabei Stickstoff, Kohlenstoff, Silicium und/oder Bor. Hierbei ist der III-V-Verbindungshalbleiter ein III-V-N-Verbindungshalbleiter. Beispiele für derartige Materialien für die Blockerschicht sind GaAsN, GaPN, GaInN, AlInN, GaInAsN, GaAsNP oder GaInAsNP. Der Stickstoff ist in einer Konzentration von 0,5 % bis 5 %, vorhanden. Die Blockerschicht kann dabei sowohl gitterfehlangepasst als auch gitterangepasst aufgewachsen werden. Die Schichten können dabei bevorzugt kohärent (d.h. komplett verspannt oder mit gleicher Gitterkonstante) ohne Versetzungen aufgewachsen werden. Die Schichtdicken müssen dabei unterhalb der kritischen Schichtdicke des Materialsystems bleiben, d.h. die Schichtspannungen dürfen nicht durch die Generation von Fehlanpassungsversetzungen relaxieren. Die kritische Schichtdicke ist für jede Materialkombination unterschiedlich, abhängig von der Gitterfehlanpassung. Die kritische Schichtdicke kann dabei mit Hilfe der Näherung von J. W. Matthews, Phil. Mag. 13, 1966, 1207 sowie J. W. Matthews, S. Mader, und T. B. Light, J. Appl. Phys. 41, 1970, 3800, abgeschätzt werden.

Die III-V-Verbindungshalbleiter der Schichtstrukturen, die für das erfindungsgemäße Bauelement eingesetzt werden, umfassen jede Kombination von Al, Ga, In mit P, As, Sb und Stickstoff. Beispiele sind hierfür GaAs, InP, GaP, AlAs, AlP, GaSb, GaN, AlN, InN sowie Verbindungen dieser binären Halbleiter. Beispiele für weitere Kombinationen sind GaInP, GaInAs, AlGaAs, AlGaInP, GaInNAs, AlGaInAs, GaInAsP, GaPN sowie GaInAsPN. Die Anteile der einzelnen Elemente können dabei variieren.

Der III-V-Halbleiter der Pufferschicht ist dabei ausgewählt aus Ga₁₋ₓInₓAs oder GaAsₓP₁₋ₓ oder GaAsₓSb₁₋ₓ. Auch hier kann der Anteil x zwischen 0 und 1 variieren.

Die Pufferschicht ist dabei so aufgebaut, dass die Gitterkonstante innerhalb der mindestens einen Pufferschicht kontinuierlich und/oder in Stufen abnimmt, wobei die Veränderung der Gitterkonstante innerhalb der Pufferschicht > 0,5 %, besonders bevorzugt > 1 % ist.

Die Blockerschichten des erfindungsgemäßen Halbleiterbauelementes können mittels Transmissions-Elektronen-Mikroskopie (TEM) und/oder hochauflösender Röntgenbeugung (HRXRD) sowie Sekundärionen-Massenspektroskopie (SIMS) nachgewiesen werden. Der Stickstoffgehalt einer III-V-N-Blockerschicht kann durch SIMS-Messungen oder energiedispersiver Röntgenbeugung (EDX) bestimmt werden.

Bevorzugt handelt es sich beim Halbleiterbauelement nach der Erfindung um eine Solarzelle, besonders bevorzugt um eine Mehrfachsolarzelle oder um eine Leuchtdiode.

Die Erfindung wird nachfolgend anhand von sechs Figuren näher beschrieben.
Figur 1 zeigt in Form einer Graphik die Veränderung der Bandlückenenergie (in eV) zur Gitterkonstante (in Å) einiger III-V-Halbleiter sowie von Silicium und Germanium.
Figur 2 zeigt in Figur 2a eine Prinzipskizze der Schichtstruktur der gitterfehlangepassten GaInP/GaInAs/Ge-Tripelsolarzelle und in Figur 2b eine entsprechende TEM-Hellfeldabbildung.
Figur 3 zeigt exemplarisch eine TEM-Hellfeldabbildung einer erfindungsgemäßen Struktur aus einem GaAs₁₋ₓPₓ/GaAs-Pufferstruktur mit integrierter Blockerschicht und die entsprechenden Schichtparameter.
Figur 4 zeigt ein erstes Ausführungsbeispiel eines erfindungsgemäßen Halbleiterbauelementes mit einer Pufferstruktur und einer Blockerschicht.
Figur 5 zeigt ein zweites Ausführungsbeispiel, bei dem ein aktiviertes Substrat vorliegt.
Figur 6 zeigt ein weiteres Ausführungsbeispiel, bei dem mehrere Schichtstrukturen übereinander angeordnet sind.
Figur 7 zeigt ein weiteres Ausführungsbeispiel.

Figur 1 beschreibt das gezielte Anpassen der Bandlücke und/oder der Gitterkonstante von III-V-Verbindungshalbleitern aus drei oder mehr Elementen.

Figur 2 beschreibt den Stand der Technik in Form von Mehrfachsolarzellen mit definierten Pufferstrukturen. Der Aufbau der in Figur 2a dargestellten Mehrfachsolarzelle ist aus A. W. Bett et al. in MRS Symp. Proc. Vol. 836 (Materials for Photovoltaics), 2005, 223-234, bekannt. In Figur 2a bedeuten hierbei a) Rückseitenkontakt, b) Ge-Unterzelle, c) GaInₓAs₁₋ₓ-Puffer, d) untere Tunneldiode, e) GaInAs-Mittelzelle, f) obere Tunneldiode, g) GaInP-Oberzelle, h) Vorderseitenkontakte und i) bezeichnet die Antireflexschicht. Die dort gezeigten Pufferstrukturen weisen einen stufenweisen, erhöhten In-Gehalt auf, um gitterfehlangepasste Solarzellenschichten defektfrei auf einem aktivierten Substrat, wie z.B. einem Germanium-Substrat, abscheiden zu können. Die Figur 2a zeigt eine Prinzipskizze einer derart gitterfehlangepassten GaInP/GaInAs/Ge-Tripelsolarzelle. Die TEM-Hellfeldabbildung in Figur 2b zeigt ein Netzwerk von Versetzungen in der Pufferstruktur. Die Fehlanpassungsvernetzungen in den Grenzflächen sorgen für einen Abbau der Schichtspannungen aufgrund unterschiedlicher Gitterkonstanten der Materialien. Die Versetzungsdichten in Halbleiterschichten auf einer solchen Pufferstruktur liegen im Bereich von 10⁶ cm⁻² bei einer Fehlanpassung der Gitterkonstante von 1,1 %. Diese Versetzungsdichten wirken sich bereits negativ auf den erreichbaren Wirkungsgrad der Solarzellen aus.

Ähnlich wie bei einer Fehlanpassung der Gitterkonstante in den Halbleiterschichten führen auch unterschiedliche Ausdehnungskoeffizienten in Materialien zu Spannungen beim Abkühlen der Struktur nach dem Wachstumsprozess. Auch hier kann es zur Bildung von Versetzungen und Rissen in den Halbleiterschichten kommen. Dies findet man heute insbesondere bei III-V-Halbleiterschichten auf Siliciumsubstrat, wo die Unterschiede in den Ausdehnungskoeffizienten besonders groß sind.

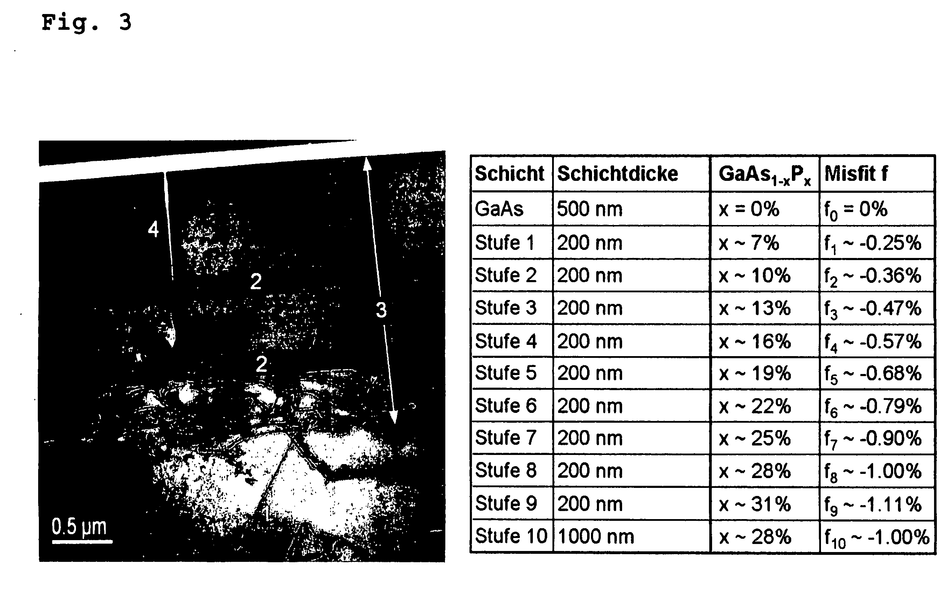

Figur 3 zeigt nun ausschnittsweise ein erfindungsgemäßes Halbleiterbauelement, bestehend aus einem GaAs-Substrat 1, einer Blockerschicht 2 sowie einer GaAsP-Pufferschicht 3 und einer zusätzlichen darauf aufgewachsenen Blockerschicht 2. Die Blockerschichten aus GaAsN wurden gitterangepasst an die jeweils darunter liegende GaAs₁₋ₓPₓ-Pufferschicht aufgewachsen. In der Tabelle in Figur 3 sind die Schichtdicken und die Phosphorkonzentrationen der einzelnen Pufferschichten sowie die jeweiligen Gitterfehlanpassungen zum GaAs-Substrat angegeben. Die Blockerschichten mit einer Dicke von 200 nm wurden zwischen die dritte und vierte Pufferschicht und zwischen die sechste und siebte Pufferschicht integriert. Man erkennt deutlich, wie die Fehlanpassungsvoraussetzungen unterhalb und innerhalb der ersten Blockerschicht abgebogen bzw. geblockt werden. Bei weiterem Pufferwachstum wird eine tensile Schichtverspannung erzeugt, die sicherlich zur Generation von Mikrorissen führt.

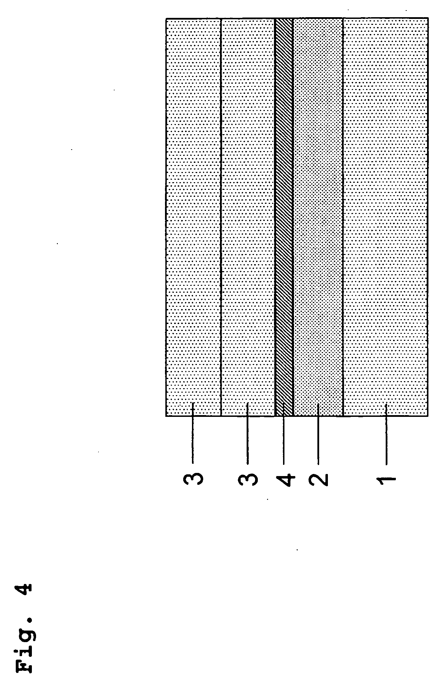

Figur 4 zeigt in schematischem Aufbau ein erstes Ausführungsbeispiel eines erfindungsgemäßen Halbleiterbauelementes. Das erste Ausführungsbeispiel beschreibt dabei ein Halbleiterbauelement, bei dem die Blockerschicht 4 oberhalb des metamorphen Puffers 2 integriert ist. Hierbei werden Versetzungen innerhalb der Blockerschicht 4 abgebogen und aus der aktiven Schicht 3, d.h. aus der Schichtstruktur, ferngehalten. Das Substrat 1 ist hierbei nicht aktiv, d.h. ohne integrierten pn- bzw. np-Übergang.

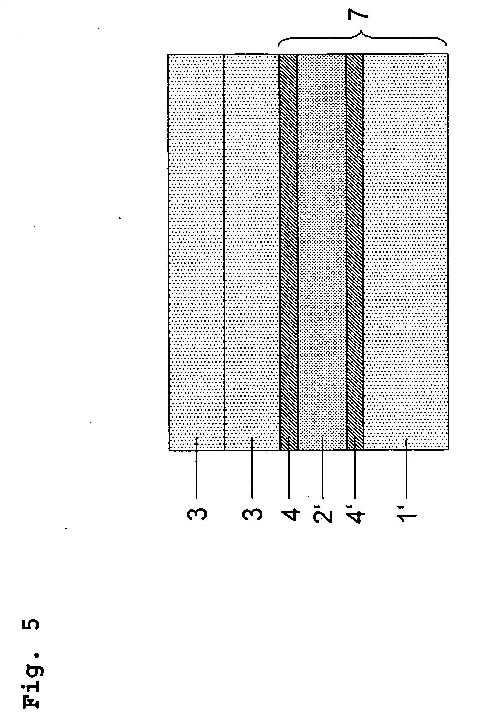

Figur 5 zeigt ein weiteres Ausführungsbeispiel, bei dem nun ein aktiviertes Substrat 7 vorliegt. Das aktivierte Substrat 7 besteht aus einem aktivierten Träger 1', der einen integrierten (eindiffundierten) pn- bzw. np-Übergang aufweist, sowie einer Blockerschicht 4', über die direkt eine Pufferschicht 2' integriert ist, um etwaige zurücklaufende Versetzungen abzublocken. Das Substrat 7 im Ausführungsbeispiel nach der Figur 5 besteht somit aus dem aktivierten Substrat 1', der Blockerschicht 4' sowie der Pufferschicht 2'. Der weitere Aufbau entspricht dann dem, wie er bereits vorstehend bei der Ausführungsform nach Figur 4 beschrieben worden ist.

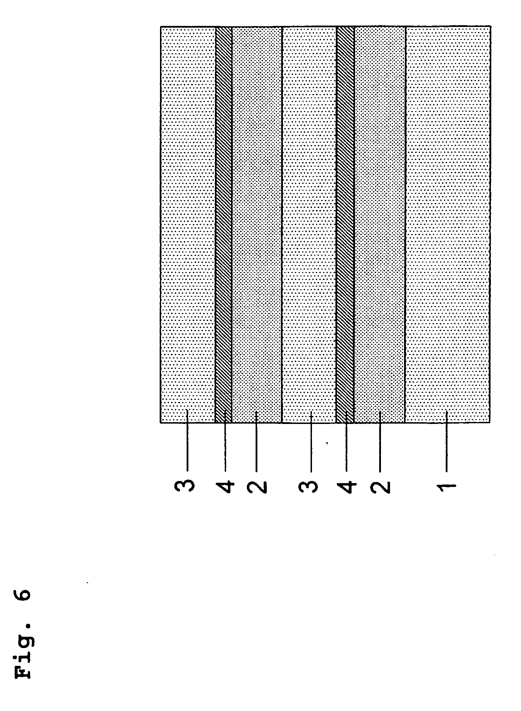

Figur 6 betrifft letztlich ein weiteres Ausführungsbeispiel, bei dem jeweils eine Blockerschicht 4 sowohl oberhalb des ersten als auch oberhalb eines weiteren Puffers integriert ist.

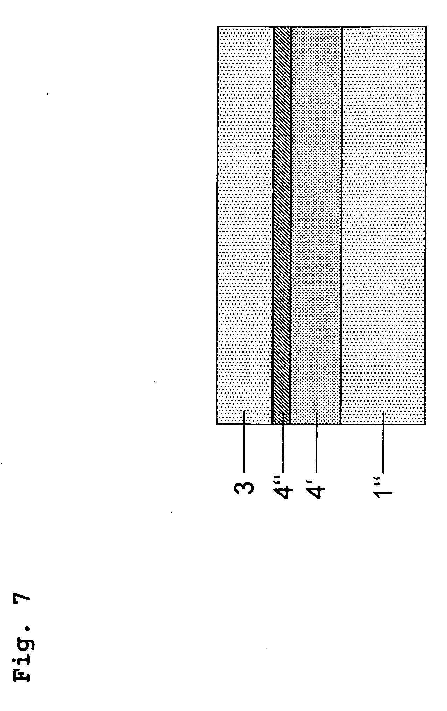

Figur 7 zeigt ein weiteres Ausführungsbeispiel eines Halbleiterbauelementes nach der Erfindung, wobei hier zwei Blockerschichten 4' und 4'' vorgesehen sind, die zwischen einem Siliciumsubstrat 1 und einer aktiven Schicht 3, wie vorstehend bei den anderen Ausführungsformen schon beschrieben, angeordnet sind. Der wesentliche Unterschied dieser Ausführungsform zu den vorstehend beschriebenen besteht darin, dass hier nun zwei "unterschiedliche" Blockerschichten 4' und 4'' verwendet worden sind, wobei die Blockerschicht 4' eine stickstoffhaltige Blockerschicht ist. Bei der Ausführungsform nach Figur 7 kann selbstverständlich auf den gezeigten Schichtstrukturen ein weiterer Schichtaufbau wie bei dem Ausführungsbeispiel nach Figur 6 erfolgen.

## Patentansprüche

1. Halmmbleiterbauelement (8) aus
• einem Substrat (1) ausgewählt aus Si, Ge, GaAs, InP, GaSb,
• mindestens einer Schichtstruktur (3) aus einem III-V-Halbleiter und/oder SiₓGe₁₋ₓ, die einen pn-oder np-Übergang bildet, sowie
• mindestens einer Pufferschicht (2) aus einem III-V-Halbleiter zur Verbindung der mindestens einen Schichtstruktur (3) mit dem Substrat (1, 7),
• zusätzlich mindestens einer Blockerschicht (4) aus III-V-Verbindungshalbleitern mit einer größeren Kristallhärte als die der mindestens einen Schichtstruktur (3), die Ausbildung und/oder Fortsetzung von Kristalldefekten verhindert oder reduziert,
**dadurch gekennzeichnet, dass**
die III-V-Verbindungshalbleiter der Blockerschicht (4) eine Stickstoffkonzentration von 0,5 % bis 5 % aufweisen,
oder
dass die III-V-Halbleiter der mindestens einen Blockerschicht (4) C, Si und/oder B enthalten.

2. Halbleiterbauelement nach Anspruch 1, **dadurch gekennzeichnet, dass** die mindestens eine Blockerschicht (4) eine Kristallhärte aufweist, die mindestens 10 %, bevorzugt 15 % größer ist als die Kristallhärte der mindestens einen Schichtstruktur (3).

3. Halbleiterbauelement nach Anspruch 1 oder 2, **dadurch gekennzeichnet, dass** die mindestens eine Blockerschicht (4) eine Dicke unterhalb der kritischen Schichtdicke für die Relaxation des Halbleiters besitzt.

4. Halbleiterbauelement nach mindestens einem der Ansprüche 1 bis 3, **dadurch gekennzeichnet, dass** die mindestens eine Blockerschicht (4) eine Dicke von 10 bis 500 nm, bevorzugt 10 bis 200 nm aufweist.

5. Halbleiterbauelement nach mindestens einem der Ansprüche 1 bis 4, **dadurch gekennzeichnet, dass** die mindestens eine Blockerschicht (4) in der mindestens einen Pufferschicht (2) angeordnet ist.

6. Halbleiterbauelement nach mindestens einem der Ansprüche 1 bis 5, **dadurch gekennzeichnet, dass** die mindestens eine Blockerschicht (4) unterhalb und/oder oberhalb der mindestens einen Pufferschicht (2) angeordnet ist.

7. Halbleiterbauelement nach mindestens einem der Ansprüche 1 bis 6, **dadurch gekennzeichnet, dass** zwei bis sechs Schichtstrukturen (3), die einen pn- oder np-Übergang bilden, vorgesehen sind.

8. Halbleiterbauelement nach Anspruch 7, **dadurch gekennzeichnet, dass** zwischen mindestens zwei Schichtstrukturen (3), die einen pn- oder np-Übergang bilden, mindestens eine Blockerschicht (4) vorgesehen ist.

9. Halbleiterbauelement nach einem der vorhergehenden Ansprüche, **dadurch gekennzeichnet, dass** die III-V-Verbindungshalbleiter ausgewählt sind aus der Gruppe bestehend aus GaAsN, GaPN, GaInN, AlInN, GaInAsN, GaAsNP oder GaInAsNP.

10. Halbleiterbauelement nach mindestens einem der vorhergehenden Ansprüche, **dadurch gekennzeichnet, dass** die mindestens eine Blockerschicht (4) kohärent und ohne Versetzungen aufgewachsen worden ist.

11. Halbleiterbauelement nach mindestens einem der vorhergehenden Ansprüche, **dadurch gekennzeichnet, dass** die mindestens eine Blockerschicht (4) Kristalldefekte und/oder Risse aufgrund unterschiedlicher thermischer Ausdehnung der mindestens einen Schichtstruktur bzw. des Substrates (1, 7) verhindert bzw. reduziert.

12. Halbleiterbauelement nach mindestens einem der vorhergehenden Ansprüche, **dadurch gekennzeichnet, dass** die III-V-Halbleiter der mindestens einen Schichtstruktur (3) ausgewählt sind aus GaAs, InP, GaP, AlAs, AlP, GaSb, GaN, AlN, InN sowie Verbindungen dieser binären Halbleiter.

13. Halbleiterbauelement nach mindestens einem der vorhergehenden Ansprüche, **dadurch gekennzeichnet, dass** die Versetzungsdichte in der mindestens einen Schichtstruktur (3) < 10⁶ cm⁻² ist.

14. Halbleiterbauelement nach mindestens einem der vorhergehenden Ansprüche, **dadurch gekennzeichnet, dass** das Substrat (1) ein einen pn- bzw. np-Übergang aufweisendes aktiviertes Substrat (7) ist.

15. Halbleiterbauelement nach vorhergehendem Anspruch, **dadurch gekennzeichnet, dass** das aktivierte Substrat (7) zusätzlich eine zwischen der Pufferschicht (2') und dem Substrat (1') angeordnete Blockerschicht (4') aufweist.

16. Halbleiterbauelement nach mindestens einem der vorhergehenden Ansprüche, **dadurch gekennzeichnet, dass** die III-V-Halbleiter der mindestens einen Pufferschicht (2) aus Ga₁₋ₓInₓAs oder GaAsₓP₁₋ₓ oder GaAsₓSb₁₋ₓ ausgewählt sind.

17. Halbleiterbauelement nach mindestens einem der vorhergehenden Ansprüche, **dadurch gekennzeichnet, dass** die Gitterkonstante innerhalb der mindestens einen Pufferschicht (2) kontinuierlich und/oder in Stufen verändert ist.

18. Halbleiterbauelement nach vorhergehende Anspruch, **dadurch gekennzeichnet, dass** die Veränderung der Gitterkonstante innerhalb der Pufferschicht (2) > 0,5 %, bevorzugt > 1 % ist.

19. Halbleiterbauelement nach mindestens einem der vorhergehenden Ansprüche, **dadurch gekennzeichnet, dass** es eine Mehrfachsolarzelle ist.

20. Halbleiterbauelement nach einem der Ansprüche 1-18, **dadurch gekennzeichnet, dass** es eine Leuchtdiode ist.

21. Verwendung des Halbleiterbauelementes nach einem der vorhergehenden Ansprüche als Solarzelle oder Leuchtdiode.

## Claims

1. Semiconductor component (8) formed of
• a substrate (1) selected from Si, Ge, GaAs, InP and GaSb,
• at least one layer structure (3) which is formed of a III-V semiconductor and/or SiₓGe₁₋ₓ and which forms a pn or np junction, and
• at least one buffer layer (2) formed of a III-V semiconductor for connecting the at least one layer structure (3) to the substrate (1, 7),
• additionally at least one blocker layer (4) which is formed of III-V compound semiconductors having a greater crystal hardness than that of the at least one layer structure (3) and which prevents or reduces the formation and/or continuation of crystal defects,
**characterised in that**
the III-V compound semiconductors of the blocker layer (4) have a nitrogen concentration of 0.5 % to 5 %,
or
**in that** the III-V semiconductors of the at least one blocker layer (4) contain C, Si and/or B.

2. Semiconductor component according to claim 1, **characterised in that** the at least one blocker layer (4) has a crystal hardness which is at least 10 %, preferably 15 % greater than the crystal hardness of the at least one layer structure (3).

3. Semiconductor component according to either claim 1 or claim 2, **characterised in that** the at least one blocker layer (4) has a thickness below the critical layer thickness for the relaxation of the semiconductor.

4. Semiconductor component according to at least one of claims 1 to 3, **characterised in that** the at least one blocker layer (4) is from 10 to 500 nm thick, preferably from 10 to 200 nm thick.

5. Semiconductor component according to at least one of claims 1 to 4, **characterised in that** the at least one blocker layer (4) is arranged in the at least one buffer layer (2).

6. Semiconductor component according to at least one of claims 1 to 5, **characterised in that** the at least one blocker layer (4) is arranged beneath and/or above the at least one buffer layer (2).

7. Semiconductor component according to at least one of claims 1 to 6, **characterised in that** two to six layer structures (3) which form a pn or np junction are provided.

8. Semiconductor component according to claim 7, **characterised in that** at least one blocker layer (4) is provided between at least two layer structures (3) which form a pn or np junction.

9. Semiconductor component according to any one of the preceding claims, **characterised in that** the III-V compound semiconductors are selected from the group consisting of GaAsN, GaPN, GaInN, AlInN, GaInAsN, GaAsNP or GaInAsNP.

10. Semiconductor component according to at least one of the preceding claims, **characterised in that** the at least one blocker layer (4) has been grown coherently and without dislocations.

11. Semiconductor component according to at least one of the preceding claims, **characterised in that** the at least one blocker layer (4) prevents or reduces crystal defects and/or cracks caused by different thermal expansion of the at least one layer structure or of the substrate (1, 7).

12. Semiconductor component according to at least one of the preceding claims, **characterised in that** the III-V semiconductors of the at least one layer structure (3) are selected from GaAs, InP, GaP, AlAs, AlP, GaSb, GaN, AlN, InN and compounds of these binary semiconductors.

13. Semiconductor component according to at least one of the preceding claims, **characterised in that** the dislocation density in the at least one layer structure (3) is < 10⁶ cm⁻².

14. Semiconductor component according to at least one of the preceding claims, **characterised in that** the substrate (1) is an activated substrate (7) comprising a pn or np junction.

15. Semiconductor component according to the preceding claim, **characterised in that** the activated substrate (7) additionally comprises a blocker layer (4') arranged between the buffer layer (2') and the substrate (1').

16. Semiconductor component according to at least one of the preceding claims, **characterised in that** the III-V semiconductors of the at least one buffer layer (2) are selected from Ga₁₋ₓInₓAs or GaAsₓP₁₋ₓ or GaAsₓSb₁₋ₓ.

17. Semiconductor component according to at least one of the preceding claims, **characterised in that** the lattice constant within the at least one buffer layer (2) is changed continuously and/or in stages.

18. Semiconductor component according to the preceding claim, **characterised in that** the change to the lattice constant within the buffer layer (2) is > 0.5 %, preferably > 1 %.

19. Semiconductor component according to at least one of the preceding claims, **characterised in that** it is a multi-junction solar cell.

20. Semiconductor component according to any one of claims 1 to 18, **characterised in that** it is an LED.

21. Use of the semiconductor component according to any one of the preceding claims as a solar cell or LED.

## Revendications

1. Composant semi-conducteur (8), constitué
- d'un substrat (1) choisi parmi Si, Ge, GaAs, InP, GaSb,
- d'au moins une structure stratifiée (3) constituée d'un semi-conducteur III-V et/ou de SiₓGe₁₋ₓ, qui forme une jonction PN ou NP, ainsi que
- d'au moins une couche tampon (2), constituée d'un semi-conducteur III-V, destinée à relier la au moins une structure stratifiée (3) au substrat (1, 7),
- en outre d'au moins une couche de blocage (4), constituée de semi-conducteurs composés III-V, ayant une dureté cristalline supérieure à celle de la au moins une structure stratifiée (3), qui empêche ou réduit la formation et/ou la continuation de défauts cristallins,
**caractérisé en ce que**
les semi-conducteurs composés III-V de la couche de blocage (4) présentent une concentration d'azote de 0,5 à 5 %,
ou
que les semi-conducteurs III-V de la au moins une couche de blocage (4) contiennent C, Si et/ou B.

2. Composant semi-conducteur selon la revendication 1, **caractérisé en ce que** la au moins une couche de blocage (4) présente une dureté cristalline qui est d'au moins 10 % et de préférence de 15 % supérieure à la dureté cristalline de la au moins une structure stratifiée (3).

3. Composant semi-conducteur selon la revendication 1 ou 2, **caractérisé en ce que** la au moins une couche de blocage (4) possède une épaisseur inférieure à l'épaisseur de couche critique pour la relaxation du semi-conducteur.

4. Composant semi-conducteur selon au moins l'une des revendications 1 à 3, **caractérisé en ce que** la au moins une couche de blocage (4) présente une épaisseur de 10 à 500 nm, de préférence de 10 à 200 nm.

5. Composant semi-conducteur selon au moins l'une des revendications 1 à 4, **caractérisé en ce que** la au moins une couche de blocage (4) est agencée dans la au moins une couche tampon (2).

6. Composant semi-conducteur selon au moins l'une des revendications 1 à 5, **caractérisé en ce que** la au moins une couche de blocage (4) est agencée en dessous et/ou au-dessus de la au moins une couche tampon (2).

7. Composant semi-conducteur selon au moins l'une des revendications 1 à 6, **caractérisé en ce que** deux à six structures stratifiées (3) sont prévues, qui forment une jonction PN ou NP.

8. Composant semi-conducteur selon la revendication 7, **caractérisé en ce qu'**au moins une couche de blocage (4) est prévue entre au moins deux structures stratifiées (3) formant une jonction PN ou NP.

9. Composant semi-conducteur selon l'une des revendications précédentes, **caractérisé en ce que** les semi-conducteurs composés III-V sont choisis dans le groupe consistant en GaAsN, GaPN, GaInN, AlInN, GaInAsN, GaAsNP ou GaInAsNP.

10. Composant semi-conducteur selon au moins l'une des revendications précédentes, **caractérisé en ce que** l'on a fait croître la au moins une couche de blocage (4) de manière cohérente et sans dislocations.

11. Composant semi-conducteur selon au moins l'une des revendications précédentes, **caractérisé en ce que** la au moins une couche de blocage (4) empêche ou réduit des défauts cristallins et/ou des fissures dus à une différence de dilatation thermique de la au moins une structure stratifiée ou du substrat (1, 7).

12. Composant semi-conducteur selon au moins l'une des revendications précédentes, **caractérisé en ce que** les semi-conducteurs III-V de la ou des structures stratifiées (3) sont choisis parmi GaAs, InP, GaP, AlAs, AlP, GaSb, GaN, AIN, InN, ainsi que les composés de ces semi-conducteurs binaires.

13. Composant semi-conducteur selon au moins l'une des revendications précédentes, **caractérisé en ce que** la densité de dislocations dans la au moins une structure stratifiée (3) est < 10⁶ cm⁻².

14. Composant semi-conducteur selon au moins l'une des revendications précédentes, **caractérisé en ce que** le substrat (1) est un substrat activé (7) présentant une jonction PN ou NP.

15. Composant semi-conducteur selon la revendication précédente, **caractérisé en ce que** le substrat activé (7) présente en outre une couche de blocage (4') agencée entre la couche tampon (2') et le substrat (1').

16. Composant semi-conducteur selon au moins l'une des revendications précédentes, **caractérisé en ce que** les semi-conducteurs III-V de la au moins une couche tampon (2) sont choisis parmi Ga₁₋ₓInₓAs ou GaAsₓP₁₋ₓ ou GaAsₓSb₁₋ₓ.

17. Composant semi-conducteur selon au moins l'une des revendications précédentes, **caractérisé en ce que** la constante de réseau est modifiée de manière continue et/ou par paliers à l'intérieur de la au moins une couche tampon (2).

18. Composant semi-conducteur selon la revendication précédente, **caractérisé en ce que** la modification de la constante de réseau à l'intérieur de la couche tampon (2) est > 0,5 %, de préférence > 1 %.

19. Composant semi-conducteur selon au moins l'une des revendications précédentes, **caractérisé en ce qu'**il s'agit d'une cellule solaire multicouche.

20. Composant semi-conducteur selon l'une des revendications 1 à 18, **caractérisé en ce qu'**il s'agit d'une diode électroluminescente.

21. Utilisation du composant semi-conducteur selon l'une des revendications précédentes en tant que cellule solaire ou diode électroluminescente.
